Europäisches Patentamt

European Patent Office

Office européen des brevets

(11) Publication number: 0 214 030
A2

## EUROPEAN PATENT APPLICATION

(21) Application number: 86401783.5

(22) Date of filing: 08.08.86

(51) Int. Cl.⁴: H 05 K 3/34

(30) Priority: 12.08.85 US 764534

(43) Date of publication of application:
11.03.87 Bulletin 87/11

(84) Designated Contracting States:
AT BE CH DE FR GB IT LI LU NL SE

(71) Applicant: DIGITAL EQUIPMENT CORPORATION
146 Main Street
Maynard, MA 01754 (US)

(72) Inventor: Kolesar, Michael J.
4 Fairfax Avenue Apt 374
Derry New Hampshire (US)

(74) Representative: Mongrédien, André et al
c/o BREVATOME 25, rue de Ponthieu
F-75008 Paris (FR)

(54) Surface mount technology automated repair system.

(57) In equipment for assembling a plurality of electronic components (42) on a circuit board (50 including means (26A,26B,28,30) for manipulating the components relative to the board, and processor means for controlling the manipulating means in a predetermined sequence to effect assembly of the components on the board, repair apparatus for removing faulty components from boards after assembly comprising:
a source of heat;
means (72) for applying heat from said heat source to a faulty component to be removed from a board, said heat applying means being carried by and movable with the component manipulating means (26A,26B,28,30), and
means for enabling the processor means selectively to activate said heat source, said heat applying means and the component manipulating means in a predetermined repair sequence to remove said faulty component from said board.

FIG. I

**Description**

## SURFACE MOUNT TECHNOLOGY AUTOMATED REPAIR SYSTEM

Field of the Invention

This invention relates generally to electronic circuit board assembly, and more particularly, to the repair of surface mount technology electronic printed circuit boards.

Background of the Invention

Electronic circuit assemblies which include a plurality of different electronic components mounted together on a single board are common in computers and other such electronic equipment. The different electronic components have leads which are electrically interconnected by conductive circuit paths plated directly on the board.

In conventional assemblies of this type, the electronic components are mounted on one surface of the board, and the leads of the components pass through plated holes to the opposite surface of the board where they are soldered to secure the components in place. Surface mount technology (SMT) boards differ from conventional boards in that the component leads are soldered to conductive pads on one surface of the board, and need not, and generally do not, pass through holes to the opposite surface of the board.

Surface mount technology is finding increasing usage in the manufacture of component assemblies because it has marked advantages over conventional technology. Specifically, SMT board assembly procedures are generally simpler and more economical to implement than conventional board assembly procedures. Moreover, they permit significant reductions in individual component and board sizes, as well as component mounting on both surfaces of the board, making denser assemblies with increased computational capacities available.

In a typical automated SMT board assembly line, plated boards are first passed through a screen print solder paste applicator, which applies solder paste to the conductive pads of the board. This is typically accomplished by forcing the solder paste onto the board through a screen or stencil, the openings in which are etched to match the shape and location of the conductive pads on the board which are to receive the solder.

Each board is then mounted in a so-called onsertion station. The onsertion station includes a table for holding the board, and a head which carries a component grappling chuck and which is moveable about X, Y, Z and ϑ (rotational) axes under control of a processor. The onsertion station can be programmed so that the chuck picks up an individual component from a feeder location, positions the component above the appropriate conductive pads on the board, moves the component downwardly to position its leads in the solder paste, releases the component, and then repeats the procedure for another component until the board is fully populated. The populated boards are then passed through equipment to harden and fuse the solder, thus securing the components in place.

Quality control efforts notwithstanding, end-of-line testing of the assembled SMT boards often uncovers boards having one or more individual components which are faulty, and which must be replaced. In order to remove a faulty component from an SMT board, the solder holding its leads must be reflowed or melted by heating, and the heating must be localized and carefully controlled to avoid damage to the board as well as damage to the other "good" components mounted on the board. Presently, this type of board repair is handled manually on a component-by-component basis using one of two alternative methods.

The first repair method involves the use of a hand-held soldering iron, which functions much like a pair of tweezers. The tips of the iron, when squeezed together, have a shape matching the perimeter of the component to be removed. The tips of the iron are positioned about the leads of the faulty component and the iron is heated until the operator observes that the solder has reflowed so as to permit the component to be lifted from the board. This method of repair is not only slow and tedious, but requires a different soldering iron for each component size or type on the board. In the case of relatively small components, this method is extremely difficult to perform.

The second repair method involves the use of a hot air station. The hot air station includes a holder for the board to be repaired, an air blower, a heater for heating the air from the blower, and a conduit for directing the hot air through an interchangeable orifice onto the component to be removed from the board. The orifice size is selected to match the perimeter of the component to be removed. After the board is positioned in the holder and the appropriately sized orifice is inserted in the conduit and aligned over the component. the blower and heater are activated to discharge hot air onto the component. When the operator observes that the solder holding the leads of the component has reflowed, the component is lifted manually from the board. This repair method is also relatively slow and tedious. It is further disadvantaged by the fact that the station must be allowed to cool down, and the orifice changed, in order to remove or replace a faulty component of a different size from the same board.

In light of the above, it is an object of this invention to provide an improved system for the repair of surface mount technology (SMT) circuit assemblies.

Another object of this invention is to provide an SMT circuit board repair system which is automated, requiring little or no operator involvement.

Still another object of the invention is to provide an SMT circuit board repair system which can be implemented with relatively simple and straightforward modification of existing equipment utilized in the assembly of such boards.

Still yet another object of the invention is to provide an SMT circuit board repair system which minimizes the likelihood of damage to the board and to other "good" components on the board by enabling precise, careful control of the repair procedure.

Other objects will be specified in or obvious from the detailed description of illustrative embodiments of the invention which follows.

## Summary of the Invention

In accordance with the present invention, repair of surface mount technology (SMT) circuit boards is effected by taking advantage of the manipulative capabilities of automated equipment conventionally used in the assembly of such boards. Specifically, automated onsertion equipment used in mounting SMT components to boards is modified to add a localized and controllable heating feature to the component grappling mechanism therein. In this way, the onsertion equipment, through appropriate programming, can be used in a repair mode in which the heating feature is activated to reflow lead solder whenever end-of-line testing indicates that a given component is faulty and must be removed and replaced on a given board.

In accordance with an illustrative embodiment of the invention, a commercially available programmable onsertion station is provided with a source of hot air which is conducted through air passages to nozzles formed in the component-engaging face of a grappling chuck. The onsertion station is programmed to operate in a repair mode by inputting data identifying the component or components which are faulty on a given board. After the board to be repaired is mounted in the station, the repair program is run, causing the chuck to engage a component to be removed, discharge hot air for a predetermined period of time sufficient to reflow the solder securing its leads, lift and carry the component to a disposal tray, pick-up a replacement component from a feeder, place the replacement component in position, and then discharge hot air again to secure the replacement component in position on the board. The optimum hot air discharge time periods will vary depending upon component type and size, and can be stored in the onsertion station memory in advance so that they are automatically selected and implemented during the repair procedure. This reduces the likelihood of damage to the board due to overheating as a result of error in operator judgement. Operator involvement in the repair procedure can be further minimized by inputting faulty component identifying data directly from an end-of-line test station to the modified onsertion station.

## Brief Description of the Drawing

The foregoing and other objects, features and advantages of the invention will be better understood from the following detailed description taken with the accompanying drawing in which:

FIG. 1 is a top view of an SMT onsertion station embodied in accordance with the invention to permit operation in a repair mode;

FIG. 2 is a front side view of the SMT onsertion station shown in FIG. 1;

FIG. 3 is an enlarged side view of a vacuum grappling chuck used in the SMT onsertion station shown in FIGS. 1 and 2 and provided with hot air discharge means for use in removing and replacing SMT components during board repairs; and

FIG. 4 is an enlarged side view of a mechanical grappling chuck used in the station shown in FIGS. 1 and 2 which, like the mechanical chuck shown in FIG. 3, is provided with the hot air discharge means for removing and replacing SMT components during board repairs.

## Detailed Description of Illustrative Embodiments

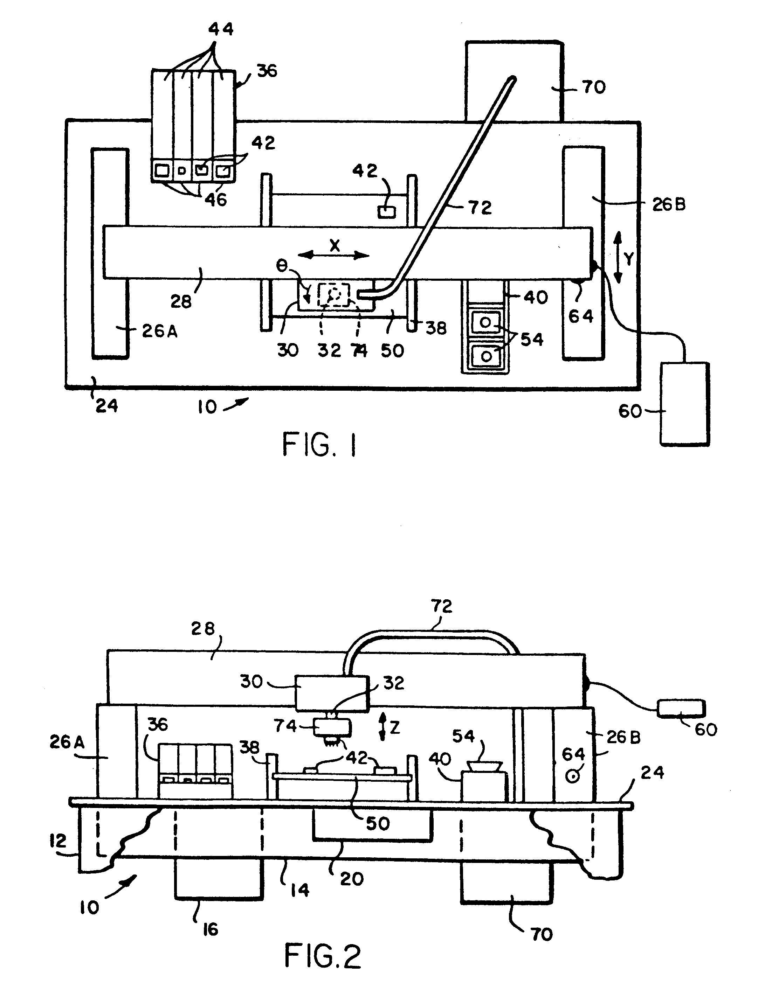

Referring now to the drawing, and initially to FIGS. 1 and 2 thereof, there is shown an automated onsertion station 10 which has been modified in accordance with the invention to operate in a repair mode. The onsertion station 10 is for the most part of conventional construction, illustratively comprising a Model QS-34 SMT assembler available commercially from Quad Systems Corporation, 2 Electronic Drive, Horsham, Pennsylvania.

Generally, the station 10 includes a base cabinet 12 which houses various equipment including a motor/driver unit 14, a vacuum pump 16 and a processor 20. A work surface mounting plate 24 is supported on top of the base cabinet 12. Mounted on the mounting plate 24 are a pair of Y-axis drive units 26A and 26B, and an X-axis drive unit 28. A Z-axis and theta ($\vartheta$) or rotational drive unit 30 is carried by the X-axis drive unit 28 and coupled to a chuck-engaging head 32. When driven by the motor/driver unit 14 under control of the processor 20, the drive units 26A, 26B, 28 and 30 are capable of moving the head 32 in any selected sequence of movements along X, Y, Z and $\vartheta$ axes, as shown in FIGS. 1 and 2.

Also mounted on the mounting plate 24 are a component feeder 36, a board holder 38, and a grappling chuck holder 40. Electronic components of different types and sizes, indicated collectively by the reference numeral 42, are fed from magazines 44 to pick-up trays 46 on the feeder 36. The board holder 38 holds an SMT printed circuit board 50 to which solder paste has been applied and on which the various electronic components 42 are to be mounted in predetermined sequence at predetermined locations. The grappling chuck holder 40 holds a plurality of different component grappling chucks 54. Each grappling chuck 54 varies in size depending upon the type and size of electronic component 42 it is intended to handle. Each chuck 54 can be gripped by the head 32, and manipulated under vacuum control between a component holding position and a component releasing position.

The processor 20 is programmable via hand-held keypad programmer 60. Using the programmer 60, a user enters instructions corresponding to each operation in sequence to be performed by the head 32 in fully populating the board 50 with components 42. The sequence of instructions, or assembly program, is stored in memory built in the processor 20, and can be rerun each time a board of the same type as the board 50 is mounted in the holder 38 for assembly. The programs stored in the processor 20 vary for different types of boards to be assembled. Additional programming capability and memory capacity can be provided through the use of a compatible off-line processor (not shown) which communicates with the on-board processor 20 through an RS-232C communication port 64.

The construction and operation of the onsertion station 10, as described so far, are conventional. Those desiring further details in this regard are referred to Model QS-34 Assembler User Manual and other Model QS-34 product literature available directly from Quad Systems Corporation.

In order to permit the onsertion station 10 of FIGS. 1 and 2 to operate in a repair mode, the station 10 is provided with a source of hot air 70, illustratively shown mounted to the rear of base cabinet 12. The air emitted by source 70 is preferably deionized so as to avoid electrostatic charge build-up and discharge damage to "good" components 42 on a board during a repair operation. The temperature of the air emitted by the source 70 should be sufficiently high to reflow the solder used in securing components 42 to the board 50 so that the components can be readily lifted from the board. For the case of commonly used tin-lead eutectic solders, hot air temperatures in the range of about 425 to 450 ˚F are generally sufficient.

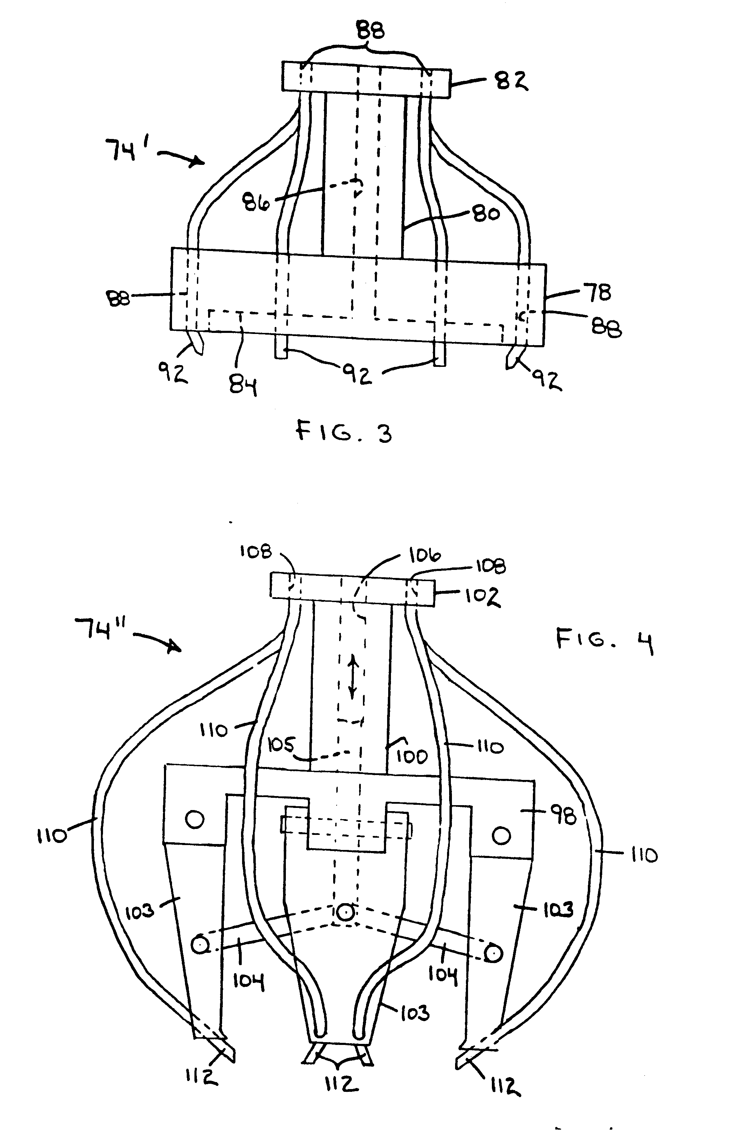

As indicated in FIGS. 1 and 2, the hot air from hot air source 70 is conducted via flexible tubing 72 to the upper surface of the Z/θ axes drive unit 30. In the unit 30, the hot air is conducted by suitable passages to the head 32, and from the head 32, to a specially designed component grappling chuck 74 adapted for use in a repair mode. FIGS. 3 and 4 illustrate two alternative embodiments of the repair chuck 74.

Chuck 74' shown in FIG. 3 is a vacuum type chuck modified for use in a repair mode. The chuck 74' includes a disc-shaped base 78, an upstanding neck 80 protruding from the top of the base 78, and a flange 82 on the top end of the neck 80. The bottom surface of the base 78 is provided with a recess 84 which more or less matches the shape of the electronic component to be held with the chuck 74'. A vacuum passage 86 extends from the recess 84 up through the neck 80 and through the flange 82.

The flange 82 of the chuck 74' is grippable by the head 32 in the onsertion station 10 of FIGS. 1 and 2. When so gripped, vacuum created in the vacuum pump 16 of the station 10 can be applied through the head 32 to the vacuum passage 86 in the chuck 74' when a component is to be picked up and held in the chuck 74'. Release of the vacuum, in turn, causes the chuck 74' to release the component. These details of the design and operation of the chuck 74' are again for the most part conventional.

In accordance with the invention, the flange 82 and base 78 of the chuck 74' are provided with a plurality of hot air passages 88 disposed radially outwardly of the vacuum passage 86. The passages 88 in the flange 82 are connected to the passages 88 in the base 78 by hot air lines 90. The passages 88 in the base 78 open into nozzles 92 which are adapted to direct hot air toward the area of the leads of a component which is engaged by the chuck 74'.

When the chuck 74' is gripped by the head 32 in the onsertion station 10 of FIGS. 1 and 2, hot air generated in the hot air source 70 can be applied through the head 32 to the hot air passages 88 in the flange 82 and ultimately discharged from the nozzles 92. Thus, the chuck 74', in addition to providing the conventional component manipulating capabilities utilized in board assembly, combines these capabilities with a hot air discharge feature to enable its use in the repair of assemblied boards.

Chuck 74" shown in FIG. 4 is a mechanical chuck modified for use in board repairs. Like chuck 74' of FIG. 3, chuck 74" of FIG. 4 includes a base 98, an upstanding neck 100, and a flange 102 on the top end of the neck 100. A plurality of component gripping legs 103 are pivotally connected to an extended below the bottom of the base 98. The legs 103 are connected by pivotal mechanical linkages 104 to a piston member 105 movably disposed in a vertical channel 106 that extends upwardly from the base 98 through the neck 100 and through the flange 102.

The flange 102 of the chuck 74" is grippable by the head 32 of the onsertion station 10 of FIGS. 1 and 2. When so gripped, the head 32 can draw the piston member 105 upwardly in the channel 106 so that the legs 103 are pivoted radially inwardly, thereby to pick-up and hold a component. Alternatively, the head 32 can move the piston member 105 downwardly in the channel 106 to cause the legs 103 to be pivoted radially outwardly to release the component.

In accordance with the invention, the flange 102 of the chuck 74" is provided with a plurality of hot air passages 108 disposed radially outwardly of the vertical channel 106. The passages 108 in the flange 102 are connected to the passages 108 in the base 98 of the chuck 74" by hot air lines 110. These hot air lines 110 are preferably flexible so as not to interfere with the pivotal motion of the legs 103. At the free ends of the legs 103, the hot air lines 110 form nozzles 112 which, like the nozzles 92 in the chuck 74', discharge hot air to the area of the leads of a component which is engaged by the chuck 74".

The station 10 can be programmed to operate in a repair mode via the hand-held programmer 60 in essentially the same manner that it is programmed for the assembly of such boards, namely, by entering instructions corresponding to each operation in sequence to be performed by the station 10 in removing faulty components from a board and replacing them with "good" components. A generalized repair program can be stored in the memory of the processor 20 for each particular type of board. In such a case, the user is simply required to enter data identifying the component or components to be replaced on the board before running the repair program.

Optimum hot air discharge time periods, which provide sufficient solder reflow to permit easy removal of components by the chuck 74' or 74" but which avoid damage to the board itself as well as adjacent components, can be determined by trial and error in advance of actual production runs and stored in the memory for automatic implementation during the repair operation. Further automation of the repair operations can be achieved by coupling faulty component identifying data directly from an end-of-line board test station back to the onsertion station 10 through the RS-232C communication port 64 conventionally provided therein. Specific implementations of these and other such repair operations will be readily apparent to those skilled in the art who have a working familiarity with the Model QS-34 assembler and/or other such automated assembly equipment.

It should be understood that the above-described embodiments are intended merely to illustrate the invention and that numerous modifications and additions thereto will be recognized as possible by those skilled in the art without departing from the scope of the invention, as defined by the appended claims. For example, while hot air has been described as the means for providing the necessary solder heating during board repair, other heating means, such as electrically energized heating elements, infrared emmitters, and laser heaters, could also be used. Also, in a production embodiment of the invention, the hot air source 70 would typically be mounted internally of the base cabinet 12, and the flexible conduit 72 would typically be run internally of the various drive units therein to the head 32, in much the same way that the vacuum lines are run internally from the vacuum pump 16 to the head 32 in the commercially available station 10. Furthermore, while the illustrative embodiments have been described as a modification to the commercially available Model QS-34 assembler, the invention could readily be embodied as a modification of other similar equipment or as a specially manufactured unit. It is, accordingly, the object of the appended claims to cover these and other modifications as come within the true spirit and scope of the invention disclosed herein.

## Claims

1. In equipment for assembling a plurality of electronic components on a circuit board including means for manipulating the components relative to the board, and processor means for controlling the manipulating means in a predetermined sequence to effect assembly of the components on the board, repair apparatus for removing faulty components from boards after assembly comprising:
a source of heat;
means for applying heat from said heat source to a faulty component to be removed from a board, said heat applying means being carried by and movable with the component manipulating means; and
means for enabling the processor means selectively to activate said heat source, said heat applying means and the component manipulating means in a predetermined repair sequence to remove said faulty component from said board.

2. Repair apparatus as defined in claim 1 in which said heat source comprises a source of hot air.

3. Repair apparatus as defined in claim 2 in which said heat source comprises a source of hot deionized air.

4. Repair apparatus as defined in claim 2 in which the assembling equipment secures the electronic components to a surface of the board by solder, and in which said heat source generates hot air of a temperature sufficient to reflow the solder securing the faulty component so that the faulty component can be removed from the board by the component manipulating means.

5. Repair apparatus as defined in claim 2 in which the assembling equipment comprises surface mount technology assembling equipment which secures each of the electronic components to a predetermined location on a surface of the board, and in which said heat applying means applies heat selectively to the predetermined location of the faulty component on the board surface, thereby to avoid heating of other locations of the board and of the other components secured to the board.

6. Repair apparatus as defined in claim 1 in which the component manipulating means includes chuck means having a component engaging face and means for moving the chuck means about X, Y, Z and ϑ axes relative to the board, and in which said heat applying means comprises means for conducting heat from said heat source to the component engaging face of the chuck means.

7. Repair apparatus as defined in claim 1 in which said enabling means activates said heat source and said heat applying means so as to apply heat to the faulty component for a predetermined period of time which permits removal of the faulty component by the component manipulating means, but which avoids damage to the board and to the other components on the board.

8. Automated repair apparatus for circuit board assemblies, each of which assemblies includes a plurality of electronic components mounted on a circuit board, said apparatus being adapted to remove a faulty component from the board and comprising:
means for holding a board to be repaired;
means for manipulating components relative to said board holding means;
processor means for controlling the operation and movement of said component manipulating means in predetermined sequences;
a source of heat;
means for applying heat from said heat source to a faulty component to be removed from the board to be repaired, said heat applying means being carried by and movable with said component manipulating means; and
means for enabling the processor means selectively to activate said heat source, said heat applying means and said component manipulating means in a predetermined repair sequence to remove said faulty component from the board to be repaired.

9. Automated repair apparatus as defined in claim 8 in which said heat source comprises a source of hot air.

10. Automated repair apparatus as defined in claim 9 in which said heat source comprises a source of hot deionized air.

11. Automated repair apparatus as defined in claim 9 in which the electronic components are mounted to the board by solder, and in which said heat source generates hot air of a temperature sufficient to reflow the solder securing the faulty component so that the faulty component can be removed from the board to be repaired by said component manipulating means.

12. Automated repair apparatus as defined in claim 9 in which said circuit board assemblies comprise surface mount technology circuit board assemblies wherein each of the electronic components is secured to a predetermined location on a surface of the board, and in which said heat applying means applies heat selectively to the predetermined location of the faulty component on the board to be repaired, thereby to avoid heating of other locations of the board and of the other components secured to the board.

13. Automated repair apparatus as defined in claim 8 in which said component manipulating means includes chuck means having a component engaging face and means for moving said chuck means about X, Y, Z, and ϑ axes relative to said board holding means, and in which said heat applying means comprises means for conducting heat from said heat source to the component engaging face of said chuck means.

14. Automated repair apparatus as defined in claim 8 in which said processor means includes memory means for storing data identifying the faulty component on the board to be repaired and the sequence of operations to be performed by said heat source, said heat applying means and said component manipulating means in removing the faulty component from the board.

15. Automated repair apparatus as defined in claim 8 in which said processor means includes memory means for storing data representing a predetermined time period for activation of said heat applying means for each faulty component to be removed.

16. Automated repair apparatus as defined in claim 8 in which enabling means further enable said processor means selectively to activate said heat source, said heat applying means and said component manipulating means in said predetermined repair sequence to mount a new component in place of the faulty component removed from the board.

FIG. 1

FIG.2

FIG. 3

FIG. 4